# EUROPÄISCHE PATENTSCHRIFT

(11) **EP 0 486 501 B1**
(45) Veröffentlichungstag und Bekanntmachung des Hinweises auf die Patenterteilung: **28.09.1994**
(21) Anmeldenummer: 90909334.6
(22) Anmeldetag: 26.06.1990
(51) Int. Cl.: G01R 31/00, B60R 16/02, G07C 5/10

(54) **VORRICHTUNG ZUR FUNKTIONSKONTROLLE MEHRERER STEUERGERÄTE IN EINEM KRAFTFAHRZEUG**
DEVICE FOR MONITORING THE FUNCTIONS OF A PLURALITY OF CONTROL UNITS IN A MOTOR VEHICLE
DISPOSITIF POUR LE CONTROLE DU FONCTIONNEMENT DE PLUSIEURS APPAREILS DE COMMANDE DANS UN VEHICULE AUTOMOBILE

(30) Priorität: 08.08.1989 DE 3926172; 20.10.1989 DE 3934974
(43) Veröffentlichungstag der Anmeldung: 27.05.1992
(73) Patentinhaber: ROBERT BOSCH GMBH, 70442 Stuttgart (DE)
(72) Erfinder: PRZYBYLA, Bernd, D-7141 Schwieberdingen (DE); PALESCH, Reinhard, D-7147 Eberdingen-Hochdorf (DE)
(86) Internationale Anmeldenummer: DE9000481
(87) Internationale Veröffentlichungsnummer: WO9102257

(56) Entgegenhaltungen:
- EP-A- 0 072 000
- EP-A- 0 225 971
- EP-A- 0 303 059
- WO-A-86/01620
- WO-A-88/02122
- DE-A- 3 309 920
- DE-A- 3 440 555
- US-A- 4 825 362

## Beschreibung

### Stand der Technik

Die Erfindung betrifft eine Vorrichtung zur Funktionskontrolle mehrerer Steuergeräte in einem Kraftfahrzeug mittels einer einzigen Kontrollanzeige.

In heute gebräuchlichen Fahrzeugen sind gewöhnlich mehrere elektronische Steuergeräte vorgesehen, die spezifische Arbeits- und Sicherheitsfunktionen beim Betrieb des Fahrzeugs erfüllen. Derartige Steuergeräte dienen beispielsweise zur Steuerung und/oder Regelung der Zündung, der Kraftstoffzuführung, des Getriebes, der Verhinderung eines Schlupfes, der Leistung, des Abgases, des Bremsvorgangs und dgl.. Diese Steuergeräte sind gewöhnlich über einen gemeinsamen Diagnosebus miteinander verbunden, an dem ein Diagnoseanschluß vorgesehen ist, um die Steuergeräte auf ihren ordnungsgemäßen Zustand hin mittels eines Testgeräts überprüfen zu können. Ferner können die Steuergeräte über einen Kommunikationsbus (z.B. CAN-Bus) miteinander verbunden sein.

Jedem Steuergerät ist eine z.B. als Kontrolleuchte ausgebildete Kontrollanzeige zugeordnet, die aufleuchtet, wenn das zugeordnete Steuergerät einen Fehler aufweist. Nach dem Einschalten der Versorgungsspannung findet in jedem Steuergerät ein sogenannter Aufprüfvorgang, der das Einschalten der Kontrolleuchte eines jeden Steuergeräts zum Zwecke der Anzeige der Funktionstüchtigkeit sowohl eines jeden Steuergeräts als auch der zugehörigen Kontrolleuchte darstellt, statt. Der Aufprüfvorgang wird nach einer vorbestimmten Zeit oder bei Eintreffen eines bestimmten Ereignisses, z.B. dem Starten des Motors, beendet. Diese Aufprüfung entspricht dem heute üblichen Verfahren bei anderen im Armaturenbrett verbauten Kontrolleuchten, z.B. der Ölkontrolleuchte. Der Verkabelungsaufwand ist bei dieser Lösung sehr groß, insbesondere wenn eine große Anzahl von Steuergeräten vorgesehen ist. Weiterhin ist für jede Kontrolleuchte eine Treiberstufe erforderlich, wodurch die Vorrichtung teuer und aufwendig wird.

Weiterhin ist es aus der EP 303 059 A1 bekannt, für mehrere Steuergeräte, die untereinander über einen Diagnosebus miteinander verbunden sind, nur eine einzige Kontrolleuchte vorzusehen, die von jedem Steuergerät aus- und eingeschaltet werden kann. Jedes der Steuergeräte besitzt Diagnosemittel, die bestimmte Fehler des Steuergerätes erkennen und einen dementsprechenden Fehlercode in einem Speicher abspeichern. Die Fehlerausgabe kann über einen Taster, der mit dem Diagnosebus verbunden ist, angestoßen werden. Anschließend findet dann die Fehlerausgabe der einzelnen Steuergeräte nacheinander in einer bestimmten Reihenfolge statt.

### Vorteile der Erfindung

Die erfindungsgemäße Vorrichtung mit den kennzeichnenden Merkmalen des Anspruchs 1 hat den Vorteil, daß unter Verwendung von ohnehin vorhandenen Diagnose- und/oder Kommunikationsleitungen zwischen den Steuergeräten nur eine einzige Kontrollanzeige und eine einzige Treiberstufe zur Funktionskontrolle erforderlich sind. Ein Flackern der Kontrollanzeige kann nicht auftreten. Die Handhabung ist technisch einfach, und eine Erweiterung durch zusätzliche Steuergeräte ist ohne Probleme realisierbar. Dabei ist keine Erhöhung des ohnehin geringen Hardware-Aufwands notwendig.

Durch die in den Unteransprüchen aufgeführten Maßnahmen sind vorteilhafte Weiterbildungen und Verbesserungen der im Anspruch 1 angegebenen Vorrichtung möglich.

Als Kommunikationsleitung zwischen den einzelnen Steuergeräten wird zweckmäßigerweise der üblicherweise eine oder zwei Einzelleitungen aufweisende Diagnosebus verwendet, der zur externen Diagnose ohnehin vorhanden ist. Bei der Nutzung dieses Diagnosebusses für die Funktionskontrolle dient eine Leitung zur Übertragung der Kontrollsignale und die andere Leitung als Statusleitung, um beispielsweise die Aufprüfphase von einer externen Diagnose zu unterscheiden. Ist die Statusleitung nicht vorhanden oder anderweitig genutzt, so muß ein externes Testgerät vor Beginn einer Diagnose die Leitung mit den Kontrollsignalen abprüfen, um festzustellen, ob eine Funktionskontrolle durchgeführt wird. Erst danach darf die Diagnose stattfinden.

Das mit der Kontrollanzeige verbundene Steuergerät ist vorzugsweise eine stets im Fahrzeug vorhandenes Zentralsteuergerät, insbesondere eine Steuergerät zur Steuerung oder Regelung der Zündung und/oder Kraftstoffeinspritzung. Dadurch können die Treiberstufe und sonstige Schaltmittel zur Funktionskontrolle immer schon primär in diesem Zentralsteuergerät vorgesehen werden, während die übrigen Steuergeräte immer ohne Treiberstufe hergestellt werden können.

Ab einem Einschaltsignal werden die Kontrollsignale der einzelnen Steuergeräte in vorteilhafter Weise in einer festgelegten Reihenfolge nacheinander erzeugt und der Prüfeinrichtung zugeführt. Dabei weisen die Kontrollsignale zweckmäßigerweise festgelegte Signallängen und/oder Signalabstände auf. Die Synchronisation dieser Signalfolge ist durch den gemeinsamen Diagnosebus auf einfache Weise möglich.

Im einfachsten Falle weist die Prüfeinrichtung Mittel zum Prüfen der als einfache Impulse ausgebildeten Kontrollsignale auf Vollständigkeit auf. Die Prüfeinrichtung kann dabei z.B. eine Zählstufe sein. Es ist jedoch auch möglich, daß die Kontrollsignale als Informationsfolgen ausgebildet oder mit solchen versehen sind. Hierdurch können zusätzliche Informationen erhalten werden, welche Steuergeräte in Ordnung sind und/oder welche Fehler aufgetreten sind. Dazu weisen die Informationsfolgen Informationen über den Zustand des jeweiligen Steuergeräts und/oder dessen Identifikation auf. Entsprechende Daten können im Zentralsteuergerät gespeichert werden, so daß sie bei einer externen Diagnose schnell erkannt werden können, was insbesondere dann von besonderer Bedeutung ist, wenn eventuelle Fehlfunktionen einzelner Steuergeräte nur sporadisch auftreten.

Sind die Steuergeräte über einen gemeinsamen Kommunikationsbus, z.B. CAN, miteinander verbunden, geben alle Steuergeräte Informationen in oben beschriebener Art als Botschaften des zu dem Kommunikationsbus gehörenden Übertragungsprotokolls an das zentrale Steuergerät weiter.

Eine Fehleranzeige oder Identifikation von fehlerhaften Steuergeräten kann auch optisch dem Fahrer dadurch mitgeteilt werden, daß die Kontrollanzeige festgelegte Leuchtfolgen und/oder Intensitätsfolgen in Abhängigkeit des Ergebnisse des Funktionstests abgibt.

### Zeichnung

Ein Ausführungsbeispiel der Erfindung ist in der Zeichnung dargestellt und in der nachfolgenden Beschreibung näher erläutert. Es zeigen:
- Fig. 1: ein Blockschaltbild des Ausführungsbeispiels mit vier Steuergeräten,
- Fig. 2: ein Signaldiagramm zur Erläuterung der Wirkungsweise unter Verwendung von Kontrollimpulsen und
- Fig. 3: eine Erläuterung der Wirkungsweise eine Ausführung, bei der zusätzliche Informationsfolgen auftreten.

### Beschreibung des Ausführungsbeispiels

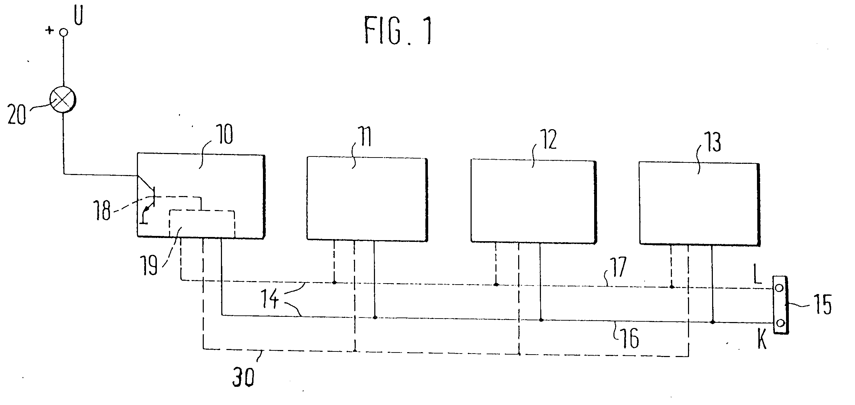

Bei dem in Fig. 1 dargestellten Ausführungsbeispiel sind vier elektronische Steuergeräte 10-13 in einem nicht dargestellten Fahrzeug angeordnet. Dabei ist das Steuergerät 10 ein in jeder Ausführung und Ausbaustufe des jeweiligen Fahrzeugs vorhandenes Steuergerät, also beispielsweise ein Zünd- und/oder Einspritzsteuergerät. Die anderen drei Steuergeräte können beispielsweise Steuergeräte zur Steuerung und/oder Regelung des Getriebes, der Verhinderung des Schlupfes, der Leistung, des Bremsvorgangs od.dgl. sein. Diese Steuergeräte 10-13 weisen gewöhnlich Mikrorechner auf und sind über einen Diagnosebus 14 untereinander und mit einem Diagnoseanschluß 15 zum Anschluß externer Diagnosegeräte verbunden. Der Diagnosebus 14 ist in vielen Fahrzeugen genormt und besteht aus einer sogenannten K-Leitung 16 und einer L-Leitung 17, die optional sind. Ferner können die Steuergeräte über einen Kommunikationsbus 30 miteinander verbunden sein.

Im als Hauptsteuergerät ausgebildeten Steuergerät 10 ist eine vereinfacht dargestellte Treiberstufe 18 vorgesehen, die von einer Prüfeinrichtung 19 gesteuert wird. An den Ausgang der Treiberstufe 18 ist eine z. B. als Kontrollleuchte 20 ausgebildete Kontrollanzeige angeschlossen, deren zweiter Anschluß mit dem positiven Pol der Versorgungsspannung U verbunden ist.

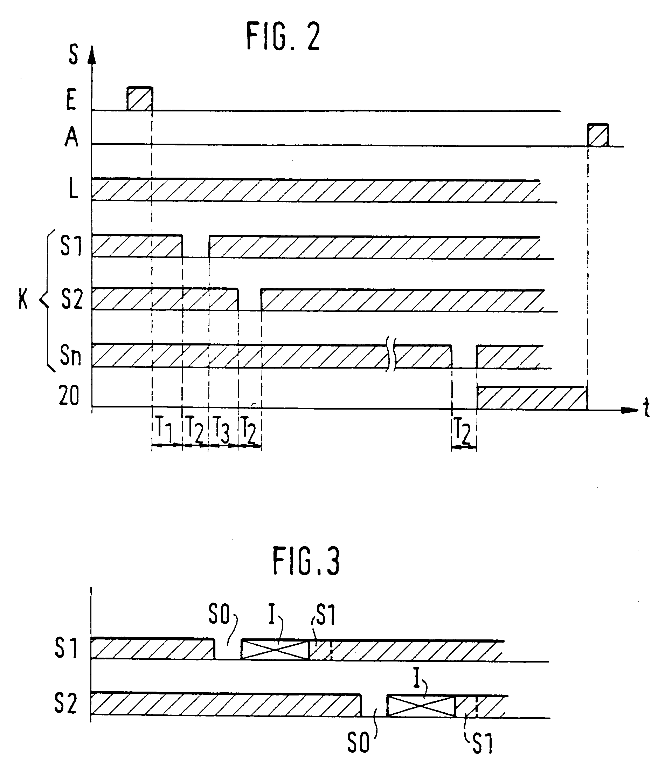

Die Wirkungsweise des in Fig. 1 dargestellten Ausführungsbeispiels wird im folgenden anhand des in Fig. 2 dargestellten Signaldiagramms erläutert.

Beim vorliegenden Ausführungsbeispiel weist die L-Leitung 17 ein 1-Signal auf, das die Funktionskontrolle gestattet. Im Falle eines externen Diagnosevorgangs würde ein 0-Signal an der L-Leitung 17 anliegen, das eine Umschaltung auf den externen Diagnosevorgang bewirkt. Über die K-Leitung erfolgt eine Synchronisation und Übertragung der einzelnen Kontrollsignale zur Prüfeinrichtung 19 im Steuergerät 10. Dies erfolgt in einem vorgesehenen Zeitraster. Auf ein Einschaltsignal E hin beginnt der Kontrollzyklus, während dem die einzelnen Steuergeräte in festgelegten Abständen T₃ Kontrollsignale der Länge T₂ abgeben. Im dargestellten Diagramm ist das Kontrollsignal des ersten, zweiten und n-ten Steuergerätes dargestellt. Der Signalabstand zwischen dem Einschaltsignal E und dem ersten Kontrollsignal beträgt T₁, wobei selbstverständlich auch hier derselbe zeitliche Abstand vorgesehen sein kann. Ebenfalls ist es prinzipiell möglich, die Kontrollsignale oder die Signalabstände unterschiedlich lang zu machen und entweder den zeitlichen Beginn der einzelnen Kontrollsignale oder der Signalabstände in ein festes zeitliches Raster zu fassen.

In der Prüfeinrichtung 19 werden die eingehenden Kontrollsignale registriert und ausgewertet. Dies kann im einfachsten Falle über eine Zähleinrichtung erfolgen, die ab dem Einschaltsignal E die eingehenden Kontrollsignale oder Kontrollimpulse nach entsprechender Impulsaufbereitung und -erkennung zählt. Ist der vorgesehene Zahlenwert, der der Zahl der angeschlossenen Steuergeräte entspricht, erreicht, so wird die ordnungsgemäße Funktion aller Steuergeräte erkannt, und es erfolgt eine entsprechende Ansteuerung der Treiberstufe 18 bzw. der Kontrolleuchte 20 bis zum Eintreffen des Ausschaltsignals A. Durch die Ansteuerung erkennt die Bedienungsperson, daß die Kontrolleuchte 20 und die Treiberstufe 18 selbst ordnungsgemäß arbeiten. Liegt in einem der Steuergeräte ein Defekt vor, so tritt vor dem Ausschaltsignal A entweder überhaupt kein Kontrollsignal auf oder das als Null-Impuls ausgebildete Kontrollsignal bleibt als Null-Signal erhalten. In beiden Fällen erfolgt dadurch eine Erkennung eines nicht ordnungsgemäßen Kontrollsignals, was die Prüfeinrichtung 19 veranlaßt, die Kontrolleuchte 20 gar nicht oder erst nach dem Signal A anzusteuern, so daß dies als Fehler erkannt wird.

In einer anderen, nicht dargestellten Variante ist es möglich, beispielsweise mit der Betätigung des Zündschlüssels vor Inbetriebnahme des Motors die Kontrolleuchte oder eine andere Kontrollanzeige aufleuchten zu lassen, die nur dann erlischt, wenn keine Fehlermeldung auftritt oder im zentralen Steuergerät nicht bereits ein Fehler gespeichert ist.

Da die Kontrollsignale in einer festgelegten Reihenfolge bei der Prüfeinrichtung 19 eingehen, ist es möglich, derartige Fehler als Fehlersignal abzuspeichern, durch das dasjenige Steuergerät gekennzeichnet wird, dessen Kontrollsignal nicht in ordnungsgemäßer Weise abgesandt wurde. Hierdurch kann bei einer externen Diagnose sofort festgestellt werden, welches der Steuergeräte einen Fehler aufweist, was insbesondere dann von besonderer Bedeutung ist, wenn dieser Fehler nur sporadisch aufgetreten ist.

Ist im Steuergerät 10 der Ausstattungsgrad des Verbundsystems der angeschlossenen Steuergeräte hinterlegt, also die Zahl und Art der angeschlossenen Steuergeräte, so kann die Prüfeinrichtung 19 durch einen entsprechenden Zugriff automatisch die Zahl der zu erwartenden Kontrollsignale erkennen und festlegen. Anderenfalls muß die Prüfeinrichtung 19 entsprechend vorprogrammiert werden.

Anstelle eines einfachen Kontrollsignals gemäß Fig. 2 können die einzelnen Steuergeräte 11-13 auch Informationsfolgen I gemäß Fig. 3 absenden. Vor jeder Informationsfolge I ist ein Start-Bit S₀ und danch ein Stopp-Bit S₁ vorgesehen. Dabei können beispielsweise die Start-Bits S₀ der einzelnen Steuergeräte in festem zeitlichem Raster nacheinander erzeugt werden. Die Informationsfolge I enthält beispielsweise die Steuergeräte-Adresse und die Kontrollmeldung des absendenden Steuergeräts. Hierdurch kann auf einfache Weise registriert werden, welches Steuergerät nicht in Ordnung ist und ob nur eine Funktionsstörung oder ein Totalausfall vorliegt, beispielsweise dann, wenn nicht nur das Kontrollsignal, sondern auch die Steuergeräte-Adresse nicht abgesandt wird. Hier ergeben sich in noch vielfältigerer Weise Möglichkeiten, die eingehenden Informationen über Störungen und Ausfälle in der Prüfeinrichtung 19 abzuspeichern, um später eine externe Diagnose zu erleichtern.

Sind die Steuergeräte über einen gemeinsamen Kommunikationsbus 30, z.B. CAN, miteinander verbunden, geben alle Steuergeräte Informationen in oben beschriebener Art als Botschaften des zu dem Kommunikationsbus gehörenden Übertragungsprotokolls an das zentrale Steuergerät weiter.

Dem Fahrer des Fahrzeugs können auch unmittelbar nach Abschluß der Funktionstests Informationen über mögliche Fehler oder Ausfälle zugeleitet werden, indem die Kontrolleuchte 20 in Abhängigkeit erkannter Störungen in einer festgelegten, codierten Weise angesteuert werden, z.B. durch verschiedene Leucht- und/oder Intensitätsfolgen. So kann beispielsweise ein dreimaliges Blinken auf einen Fehler in der Getriebesteuerung hinweisen, während ein zweimaliges Blinken einen Fehler in der Antischlupfregelung kennzeichnet.

## Patentansprüche

1. Vorrichtung zur Funktionskontrolle mehrerer Steuergeräte(10 bis 13) in einem Kraftfahrzeug mittels einer einzigen Kontrollanzeige (20), wobei die Steuergeräte (10 bis 13) über wenigstens eine Diagnose- und/oder Busleitung (16, 17, 30) miteinander in Verbindung stehen, wobei in jedem Steuergerät (10 bis 13) Mittel zur Erzeugung eines Kontrollsignals als Funktionsmeldung vorgesehen sind und wobei aufgrund dieses Kontrollsignals Informationen zur Ansteuerung der Kontrollanzeige (20) ausgebbar sind, dadurch gekennzeichnet, daß Schaltmittel (18) zur Ansteuerung der Kontrollanzeige (20) nur in einem Steuergerät (10) vorgesehen sind, daß die Kontrollsignale dem Steuergerät (10) mit den Schaltmitteln (18) zur Ansteuerung der Kontrollanzeige (20) übertragbar sind und daß das Signal für die Kontrollanzeige (20) in Abhängigkeit von den Kontrollsignalen beeinflußbar ist.

2. Vorrichtung nach Anspruch 1, dadurch gekennzeichnet, daß die Schaltmittel (18) als Treiberstufe ausgebildet sind.

3. Vorrichtung nach Anspruch 1 oder 2, dadurch gekennzeichnet, daß zwei als Diagnosebus (14) ausgebildete Diagnoseleitungen (16, 17) vorgesehen sind.

4. Vorrichtung nach Anspruch 3, dadurch gekennzeichnet, daß eine Leitung (16) zur Übertragung der Kontrollsignale und die andere Leitung (17) als Statusleitung vorgesehen ist.

5. Vorrichtung nach Anspruch 1 oder 2, dadurch gekennzeichnet, daß die Diagnoseleitung (16) als Diagnosbus (14) mit einer Einzelleitung ausgebildet ist.

6. Vorrichtung nach Anspruch 5, dadurch gekennzeichnet, daß ein externes Testgerät vor Beginn einer Diagnose die Diagnoseleitung (16) auf Vorhandensein von Kontrollsignalen der einzelnen Steuergeräte (11-13) abprüft.

7. Vorrichtung nach Anspruch 6, dadurch gekennzeichnet, daß das externe Testgerät mit der Diagnose erst dann beginnt, wenn für eine festzulegende Zeit keine Kontrollsignale auf der Diagnoseleitung (16) erkannt werden.

8. Vorrichtung nach Anspruch 1 oder 2, dadurch gekennzeichnet, daß zur Übertragung der Kontrollsignale ein Kommunikationsbus als wenigstens eine Busleitung (30) verwendet wird.

9. Vorrichtung nach einem der vorhergehenden Ansprüche, dadurch gekennzeichnet, daß das mit der Kontrollanzeige (20) verbundene Steuergerät (10) ein stets im Fahrzeug vorhandenes Zentralsteuergerät ist, insbesondere zur Steuerung oder Regelung der Zündung und/oder Kraftstoffeinspritzung.

10. Vorrichtung nach einem der vorhergehenden Ansprüche, dadurch gekennzeichnet, daß ab einem Einschaltsignal (E) die Kontrollsignale der einzelnen Steuergeräte (11 bis 13) in einer festgelegten Reihenfolge nacheinander erzeugbar und einer in dem einen Steuergerät (10) vorhandenen Prüfeinrichtung (19) zuführbar sind.

11. Vorrichtung nach Anspruch 10, dadurch gekennzeichnet, daß die Kontrollsignale festgelegte Signallängen und/oder Signalabstände aufweisen.

12. Vorrichtung nach Anspruch 10 oder 11, dadurch gekennzeichnet, daß die Prüfeinrichtung (19) Mittel zum Prüfen der als einfache Impulse ausgebildeten Kontrollsignale auf Vollständigkeit aufweist.

13. Vorrichtung nach einem der Ansprüche 10 bis 12, dadurch gekennzeichnet, daß die Kontrollsignale als Informationsfolgen (I) ausgebildet oder mit solchen versehen sind.

14. Vorrichtung nach Anspruch 13, dadurch gekennzeichnet, daß die Informationsfolgen (I) Informationen über den Zustand des jeweiligen Steuergeräts (11-13) und/oder dessen Identifikation aufweisen.

15. Vorrichtung nach Anspruch 8, dadurch gekennzeichnet, daß die Kontrollsignale als Botschaften des zu dem Kommunikationsbus (30) gehörenden Übertragungsprotokolls ausgebildet sind.

16. Vorrichtung nach Anspruch 15, dadurch gekennzeichnet, daß die Botschaften Informationen über den Zustand des jeweiligen Steuergeräts (11-13) und/oder dessen Identifikation aufweisen.

17. Vorrichtung nach Anspruch 15 oder 16, dadurch gekennzeichnet, daß die Prüfeinrichtung (19) Mittel zum Prüfen der Botschaften auf Vollständigkeit aufweist.

18. Vorrichtung nach einem der Ansprüche 10 bis 17, dadurch gekennzeichnet, daß bei ordnungsgemäß vorliegenden Kontrollsignalen die Kontrollanzeige (20) einschaltbar und durch ein Aussohaltsignal (A) oder nach einer festgelegten Zeit ausschaltbar ist.

19. Vorrichtung nach Anspruch 18, dadurch gekennzeichnet, daß bei nicht Ordnungsgemäß vorliegenden Kontrollsignalen die Kontrollanzeige (20) vor dem Ausschaltsignal (A) oder einer festgelegten Zeit nicht eingeschaltet wird.

20. Vorrichtung nach Anspruch 18, dadurch gekennzeichnet, daß bei nicht ordnungsgemäß vorliegenden Kontrollsignalen die Kontrollanzeige (20) nach dem Ausschaltsignal (A) oder einer festgelegten Zeit einschaltbar ist.

21. Vorrichtung nach einem der Ansprüche 10 bis 13, dadurch gekennzeichnet, daß die Kontrollanzeige (20) durch ein manuell auslösbares Schaltsignal, z.B. durch das Einschaltsignal eines Zündschlüssels, einschaltbar und bei ordnungsgemäß vorliegenden Kontrollsignalen ausschaltbar ist.

22. Vorrichtung nach einem der Ansprüche 18 bis 21, dadurch gekennzeichnet, daß ein Fehlersignalspeicher vorgesehen ist, der bei gespeichertem Fehlersignal die den ordnungsgemäßen Zustand anzeigende Schaltfolge der Kontrollanzeige (20) verhindert.

23. Vorrichtung nach einem der vorhergehenden Ansprüche, dadurch gekennzeichnet, daß Mittel zur Erzeugung von Leuchtfolgen und/oder Intensitätsfolgen in Abhängigkeit des Ergebnisses des Funktionstests vorgesehen sind.

## Claims

1. A device for monitoring the functions of a plurality of control units (10 to 13) in a motor vehicle by means of a single monitoring display (20), the control devices (10 to 13) being connected to one another via at least one diagnostic and/or bus line (16, 17, 30), means for producing a monitoring signal being provided as a function report in each control device (10 to 13), and it being possible for information for driving the monitoring display (20) to be output on the basis of this monitoring signal, wherein switching means (18) for driving the monitoring display (20) are only provided in one control device (10), wherein the monitoring signals can be transmitted to the control device (10) with the switching means (18) in order to drive the monitoring display (20), and wherein the signal for the monitoring display (20) can be influenced as a function of the monitoring signals.

2. The device as claimed in claim 1, wherein the switching means (18) are realized as a driver stage.

3. The device as claimed in claim 1 or 2, wherein two diagnostic lines (16, 17) which are realized as a diagnostic bus (14) are provided.

4. The device as claimed in claim 3, wherein one line (16) is provided for transmitting the monitoring signals and the other line (17) is provided as a status line.

5. The device as claimed in claim 1 or 2, wherein the diagnostic line (16) is realized as a diagnostic bus (14) with an individual line.

6. The device as claimed in claim 5, wherein, before the start of a diagnosis, an external testing unit tests the diagnostic line (16) for the presence of monitoring signals of the individual control devices (11 - 13).

7. The device as claimed in claim 6, wherein the external test device does not begin the diagnosis until no monitoring signals have been detected on the diagnostic line (16) for a period to be specified.

8. The device as claimed in claim 1 or 2, wherein a communication bus is used as at least one bus line (30) in order to transmit the monitoring signals.

9. The device as claimed in one of the preceding claims, wherein the control device (10) which is connected to the monitoring display (20) is a central control device which is always present in the vehicle, in particular for open-loop or closed-loop control of the ignition and/or fuel injection.

10. The device as claimed in one of the preceding claims, wherein, starting from a switch-on signal (E), the monitoring signals of the individual control devices (11 to 13) can be successively produced in a fixed sequence and fed to a test device (19) which is present in the one control device (10).

11. The device as claimed in claim 10, wherein the monitoring signals have specified signal lengths and/or signal distances.

12. The device as claimed in claim 10 or 11, wherein the test device (19) has means for testing the completeness of the monitoring signals which are realized as single pulses.

13. The device as claimed in one of claims 10 to 12, wherein the monitoring signals are realized as information sequences (I) or are provided with such sequences (I).

14. The device as claimed in claim 13, wherein the information sequences (I) have information relating to the state of the respective control device (11 - 13) and/or its identification.

15. The device as claimed in claim 8, wherein the monitoring signals are realized as messages of the transmission protocol which is associated with the communication bus (30).

16. The device as claimed in claim 15, wherein the messages have information relating to the state of the respective control device (11 - 13) and/or its identification.

17. The device as claimed in claim 15 or 16, wherein the test device (19) has means for testing the completeness of the messages.

18. The device as claimed in one of claims 10 to 17, wherein when monitoring signals are present in a satisfactory way the monitoring display (20) can be switched on and can be switched off by a switch-off signal (A) or after a specified time.

19. The device as claimed in claim 18, wherein, when monitoring signals are not present in a satisfactory way, the monitoring display (20) is not switched on before the switch-off signal (A) or before a specified time.

20. The device as claimed in claim 18, wherein, when the monitoring signals are not present in a satisfactory way, the monitoring display (20) can be switched on after the switch-off signal (A) or a specified time.

21. The device as claimed in one of claims 10 to 13, wherein the monitoring display (20) can be switched on by a manually triggerable switching signal, e.g. by the switch-on signal of an ignition key, and can be switched off when monitoring signals are present in a satisfactory way.

22. The device as claimed in one of claims 18 to 21, wherein a fault signal memory is provided which, when a fault signal is stored, prevents the switching sequence, which indicates the satisfactory state, of the control sequence (20).

23. The device according to one of the preceding claims, wherein means for producing light sequences and/or intensity sequences as a function of the result of the function test are provided.

## Revendications

1. Dispositif pour le contrôle du fonctionnement de plusieurs appareils de commande (10-13) d'un véhicule automobile à l'aide d'un seul affichage de contrôle (20), les appareils de commande (10-13) étant reliés par au moins une ligne de diagnostic et/ou de bus (16, 17, 30), chaque appareil de commande (10-13) ayant des moyens pour créer un signal de contrôle comme signal de fonctionnement et ce signal de contrôle permettent d'émettre des informations pour commander l'affichage de contrôle (20), caractérisé par des moyens de commutation (18) pour commander l'affichage de contrôle (20) seulement dans un appareil de commande (10), les signaux de contrôle étant transmis à l'appareil de commande (10) par les moyens de commutation (18) pour commander l'affichage de contrôle (20), et en ce que le signal peut être influencé en fonction des signaux de contrôle pour l'affichage de contrôle (20).

2. Dispositif selon la revendication 1, caractérisé en ce que les moyens de commutation (18) sont des étages de puissance.

3. Dispositif selon la revendication 1 ou 2, caractérisé par deux bus de diagnostic (14) en forme de lignes de diagnostic (16, 17).

4. Dispositif selon la revendication 3, caractérisé en ce qu'un ligne (16) est prévue pour transmettre les signaux de contrôle et l'autre ligne (17) constitue la ligne d'état.

5. Dispositif selon la revendication 1 ou 2, caractérisé en ce que la ligne de diagnostic (16) est réalisée comme bus de diagnostic (14) avec une ligne simple.

6. Dispositif selon la revendication 5, caractérisé en ce qu'un appareil d'essai externe peut contrôler, avant le début d'un diagnostic, la ligne de diagnostic (16) pour déceler l'existence de signaux de contrôle des différents appareils de commande (11-13).

7. Dispositif selon la revendication 6, caractérisé en ce que l'appareil d'essai externe ne commence seulement avec le diagnostic que si, pendant une durée à fixer, il n'a reconnu aucun signal de contrôle sur la ligne de diagnostic (16).

8. Dispositif selon la revendication 1 ou 2, caractérisé en ce que pour transmettre les signaux de contrôle, on utilise un bus de communication tel qu' au moins une ligne de bus (30).

9. Dispositif selon au moins l'une des revendications précédentes, caractérisé en ce que l'appareil de commande (10) relié à l'affichage de contrôle (20) est un appareil central de commande qui équipe toujours un véhicule et sert notamment à commander ou à réguler l'allumage et/ou l'injection.

10. Dispositif selon l'une des revendications précédentes, caractérisé en ce qu'à partir d'un signal de mise en route ou de branchement (E), les signaux de contrôle des différents appareils de commande (11-13) sont créés successivement selon un ordre fixé, pour être fournis à une installation de vérification (19) existant dans un appareil de commande (10).

11. Dispositif selon la revendication 10, caractérisé en ce que les longueurs des signaux et/ou les intervalles des signaux sont fixes pour les signaux de contrôle.

12. Dispositif selon la revendication 10 ou 11, caractérisé en ce que l'installation de vérification (19) comporte des moyens pour vérifier que des signaux de contrôle en forme de simples impulsions sont complets.

13. Dispositif selon l'une des revendications 10 à 12, caractérisé en ce que les signaux de contrôle sont en forme de suites d'informations (I) ou en comportent.

14. Dispositif selon la revendication 13, caractérisé en ce que les suites d'informations (I) présentent des informations relatives à l'état de l'appareil de commande (11-13) respectif et/ou à son identification.

15. Dispositif selon la revendication 8, caractérisé en ce que les signaux de contrôle sont des messages du protocole de transmission appartenant au bus de communication (30).

16. Dispositif selon la revendication 15, caractérisé en ce que les messages contiennent des informations relatives à l'état de l'appareil de commande (11-13) respectif et/ou à son identification.

17. Dispositif selon la revendication 15 ou 16, caractérisé en ce que l'installation de vérification (19) comporte des moyens pour vérifier que les messages sont complets.

18. Dispositif selon l'une des revendication 10 à 17, caractérisé en ce que pour des signaux de contrôle présentés correctement, l'affichage de contrôle (20) est mis en oeuvre et n'est coupé que par un signal de coupure (A) ou après une durée fixée.

19. Dispositif selon la revendication 18, caractérisé en ce qu'en l'absence de signaux de contrôle corrects, l'affichage de contrôle (20) ne se met pas en route avant le signal de coupure (A) ou une durée fixée.

20. Dispositif selon la revendication 18, caractérisé en ce que pour des signaux de contrôle non corrects, l'affichage de contrôle (20) est mis en route après le signal de coupure (A) ou après une durée fixée.

21. Dispositif selon l'une des revendications 10 à 13, caractérisé en ce que l'affichage de contrôle (20) est mis en route par un signal de commutation à déclenchement manuel, par exemple par le signal de branchement de la clé de contact, et est coupé lorsque les signaux de contrôle corrects sont fournis.

22. Dispositif selon l'une des revendications 18 à 21, caractérisé par une mémoire de signaux de défauts qui évite lorsqu'un signal de défaut est enregistré, que n'apparaisse la suite de commutations de l'affichage de contrôle (20) indiquant un état correct.

23. Dispositif selon l'une des revendications précédentes, caractérisé par des moyens pour créer des suites de signaux lumineux et/ou d'intensité en fonction du résultat du test de fonctionnement.
